# EUROPEAN PATENT APPLICATION

(11) **EP 0 756 176 A2**
(43) Date of publication of application: **29.01.1997**
(21) Application number: 95308975.2
(22) Date of filing: 11.12.1995
(51) Int. Cl.: G01R 13/22

(54) **A user interface for a graphical display device**

(30) Priority: 26.07.1995 US 507610
(71) Applicant: UNIVERSAL ENTERPRISES, INC., Beaverton, Oregon 97005 (US)
(72) Inventor: Frankovitch, Ed., Jr., Coatesville, Pennsylvania 19320 (US); Wieners, Robert J., Wrentham, Massachusetts (US)
(74) Representative: Skerrett, John Norton Haigh

(57) **Abstract**

A measuring device (10) displays waveforms representative of electrical signals and includes a selector (14), at least one input terminal (16), and a graphical display (12). The graphical display (12) is suitable to view a waveform thereon. The measuring device (10) receives an electrical signal from the input terminal (16) and displays a first waveform on the graphical display (12) representative of the electrical signal. The selector (14) is selectable to one of a plurality of positions (15a-15m) and the measuring device selects a set of waveform data in response to each of the positions. The measuring device (10) displays a second waveform on the graphical display (12) representative of the waveform data.

## Description

### Background of the Invention

The present invention relates to an interface for a graphical measuring device to simplify the operation of the measuring device for measuring electrical signals.

An oscilloscope is a device which displays a graph of voltage or current over time. In order to display meaningful information, the oscilloscope must be configured to measure voltage or current over a meaningful range of magnitudes during a proper time duration. The start of the time period for measuring voltage or current must be selected by choosing a proper triggering event based on the anticipated electrical signal to be measured. The triggering event may include the trigger level voltage and the trigger slope. For example, a triggering event could be a voltage signal rising above 0.1 volts. The time duration and voltage range should be selected so that a full electrical signal (waveform) is visible on the display. To make a meaningful interpretation of the displayed waveform, the user must know what the waveform should look like.

For example, if the user is measuring a square wave signal that varies between 0.01 volts to 0.06 volts every 100 microseconds, then it would be useless to view the square wave signal on a voltage scale set to display signals between 0 to 0.005 volts. Also, it would not be optimal to measure the square wave signal over a time duration of 10 microseconds. Further, if the triggering event was set to sense an increasing signal greater than 0.1 volts, then the square wave signal would never trigger the device and hence no waveform would be displayed. It is apparent that to simply make a proper measurement, the user must select the scaling, time duration, trigger level voltage, and the trigger slope, all for an electrical signal for which the user presumably has a prior knowledge of its characteristics. If the user does not know or cannot recall the anticipated signal's characteristics then the process to properly sense and display a waveform requires experimentation in an attempt to set all parameters. This experimentation may require considerable time and be frustrating to the user.

For the aforementioned example, a properly configured measuring device should have the voltage scale range set to 0 to 0.1 volts to permit viewing the height of the entire waveform. The time period should be set to either 500 or 1000 microseconds so that at least one entire waveform time period is displayed. The triggering event could be selected to trigger with an increasing voltage over 0.015 volts, which is above the minimum anticipated voltage of 0.01 volts. The trigger slope, if needed, would be set accordingly.

Many technicians, including automobile technicians, are likely to be unfamiliar and untrained with respect to the proper operation of such an oscilloscope. With all their other concerns, it is a time consuming burden for such technicians to be properly trained to correctly configure an oscilloscope to perform various tests and measurements. In particular for automotive technicians, many tests have become necessary with the advent of microchip controllers within automobiles.

A traditional desktop oscilloscope may be used by technicians to display measurements for testing and troubleshooting. However, as previously explained, many technicians may be unfamiliar with the proper operation of an oscilloscope. Further, it is burdensome for the technician to move desktop oscilloscopes to remote testing locations to take measurements.

Fluke Corporation of Everett, Washington, has designed and is marketing a handheld 860 series GMM (Graphical Multimeter) that displays electrical waveforms in a manner similar to that of a desktop oscilloscope. However, unlike an oscilloscope, the 860 series GMM is not capable of sampling at over 100,000 Hz which provides an inadequate display resolution for many applications. In essence, the graphical multimeter is only capable of sensing the general trends of electrical signals. In general, oscilloscopes sample at rates in excess of 1 MHz and thereby can display transients of electrical signals that the 860 series GMM, and similar graphical meters, are incapable of doing. Most oscilloscopes operate at frequencies of 5 MHz or more. Like an oscilloscope, Fluke's 860 series GMM is complicated to configure, particularly when used by an untrained technician unfamiliar with its operation. Accordingly, for technicians, and in particular automobile technicians, a graphical measuring device that is easy to configure to perform tests and measurements is desirable. Furthermore, if the technician does manage to properly configure the measuring device, the technician may still be unable to interpret the meaning of the waveform, for example, whether or not the waveform indicates the existence of a problem, without prior knowledge of how a proper waveform should appear.

Olsen, U.S. Patent No. 3,789,658 discloses an automobile engine performance analyzer which includes an oscilloscope and three selectable scale test meters for displaying certain operating characteristics of an engine under test. In particular, a program switch is provided with a rotary selector knob for positioning the switch at any selected position for measuring and displaying one of the characteristics A-L. However, the oscilloscope uses the same scaling of the graphical display for all the different tests. This does not allow optimum viewing of all waveforms (if any waveform is displayed at all), because each waveform may have a different magnitude, time duration and trigger point.

What is desired, therefore, is an interface for a graphical display device that frees the user from setting the scaling, time duration, trigger level voltage, and trigger slope for one or more user-selected tests. Furthermore, the display device should assist the user in determining whether the displayed waveform is correct.

### Summary of the Present Invention

The present invention overcomes the aforementioned drawbacks and shortcomings of the prior art by providing a measuring device that displays waveforms representative of electrical signals that includes a selector, at least one input terminal, and a graphical display suitable for viewing a waveform thereon. In a first aspect of the present invention, the measuring device receives an electrical signal from the input terminal and displays a first waveform on the graphical display which is representative of the electrical signal. The selector typically may be in the form of a rotary selector knob cooperating with a dial containing indicia associated with respective angular positions thereon. The selector is moveable to one of a plurality of positions and the measuring device then selects waveform data in response to the respective position chosen. The measuring device then displays a second waveform on the graphical display which is taken from a reference waveform data library and is representative of the waveform data type selected.

Preferably the first waveform and second waveform are simultaneously displayed on the graphical display. By displaying the second waveform, preferably indicative of a reference signal, the user can visually compare his measured signal (first waveform) to the reference waveform (second waveform) to assist in troubleshooting and testing determinations.

In a second aspect of the present invention, the measuring device is selectable to one of a plurality of positions and the measuring device selects trigger data and scaling data in response to each of the positions. The measuring device receives an electrical signal from the input terminal and displays a received waveform representative of the electrical signal on the display where the measuring device is configured in accordance with the trigger data and scaling data.

Selecting the appropriate scaling data and trigger data for the measuring device by different selector positions permit the user to simply select the test to be performed and the measuring device is consequently automatically configured. This alleviates the user from the necessity of being familiar with the operation and configuration of the measuring device aside from simply choosing the appropriate test to be performed.

The foregoing and other objectives, features, and advantages of the invention will be more readily understood upon consideration of the following detailed description of the invention, taken in conjunction with the accompanying drawings.

### Brief Description of the Drawings

FIG. 1 is a pictorial front view of a measuring device that includes a user interface constructed in accordance with the present invention.

FIG. 2 is an operational flow diagram of the measuring device and user interface shown in FIG. 1.

### Detailed Description of the Preferred Embodiment

Traditional oscilloscopes are designed as general purpose devices with extensive functionality and versatility but, as previously described, technicians may be unfamiliar with its operation and hampered by the versatility of such instruments. To cater to the need for a powerful yet simple to use measuring device, an interface is needed to free up the technician from the complicated details regarding the device's operation. An important consideration accomplished by the user interface of the present invention is that the measuring device may be specifically designed to exploit the fact that there are typically only a limited number of measurements that are performed by a specialized technician, such as an automobile technician. Ideally, the measuring device should permit the technician to merely identify the particular test to be performed and the measuring device would then properly sense and display the waveform of the electrical signal associated therewith. To sense an electrical signal which has predetermined characteristics, a good trigger level voltage and trigger slope should be automatically selected by the measuring device. In addition, to properly display the electrical signal the measuring device should automatically select a proper voltage (or current) range and time period.

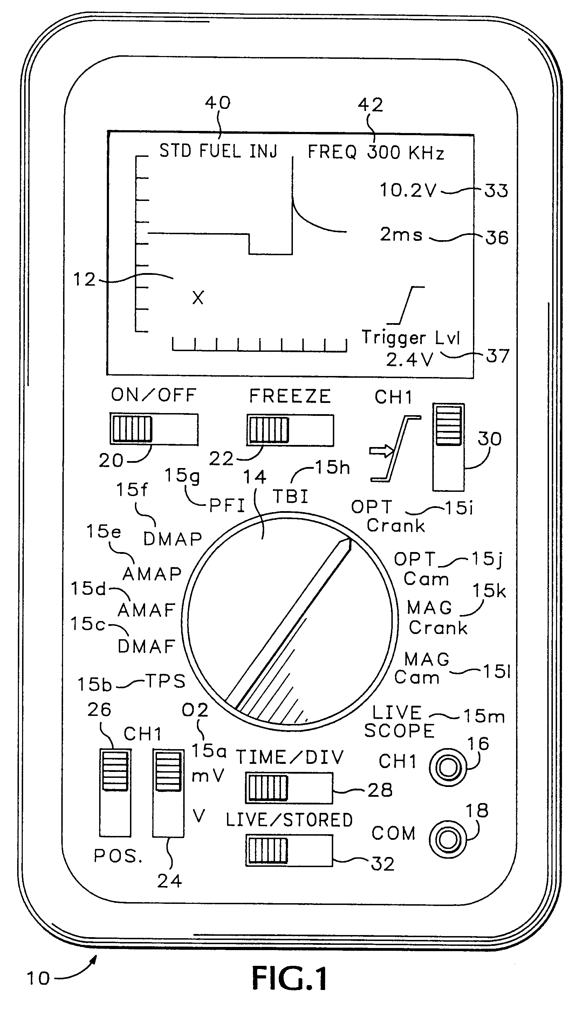

Referring to FIG. 1, the measuring device 10, which is preferably an oscilloscope, is a portable battery-powered handheld device to facilitate making measurements at remote locations. For an automotive technician, only about twelve measurements, one for each of the vehicle diagnostic sensors feeding into the vehicle's microchip, are typically performed. It turns out that the magnitude of the voltage and/or current signals detected by these sensors, when measured over a time period, varies little among different vehicles. However, the electrical signals that need to be observed do have steady state and transient characteristics which require a fast sampling rate in order to obtain an accurate waveform. The sampling rates of graphical multimeters are not fast enough to provide a waveform with sufficient resolution for such automotive testing. Accordingly, an oscilloscope which has a much higher sampling rate is necessary to properly sense and display the electrical signals of the vehicle's diagnostic microchip. (However, where the required sampling rates for the particular application are significantly lower, a graphical multimeter or some other measuring device may be adequate.)

The oscilloscope 10 preferably has about the same size, shape, and appearance as a handheld multimeter to provide portability and maintain its familiarity in appearance with technicians that are already familiar with such instruments. A graphical display 12 is located at the upper center of the oscilloscope 10. Centrally located on the oscilloscope 10 is a rotary snap-to dial 14, which in the exemplary embodiment shown has thirteen selectable positions 15a-15m. The dial may be chosen with any suitable number of positions for the particular application. The presence of the dial 14 makes the oscilloscope 10 appear familiar and acceptable to technicians who are familiar with multimeters. In the exemplary embodiment the cost of designing and manufacturing the oscilloscope is reduced because existing tooling is available for multimeters with a similar appearance.

The dial 14 provides an aspect of the user interface to simplify the operation of the oscilloscope for a technician. Each position of the dial is programmed to correspond to a particular test that is frequently performed by the technician. As shown in FIG. 1, twelve of the thirteen selectable positions correspond to individual electrical tests 15a-15l typically performed by an automotive technician in vehicle diagnostic and repair work. The thirteenth position 15m permits the oscilloscope 10 to operate in the same manner as traditional oscilloscopes, as will be described in detail later. Turning the dial 14 to one of the twelve positions corresponding to a respective one of the automotive tests, configures the oscilloscope to properly sense and display the anticipated electrical signal. The configuration performed by the oscilloscope includes automatically selecting the scaling (voltage or current), time duration, trigger level voltage, and trigger slope for the anticipated electrical signal corresponding to the dial's selected position. In this manner, the technician only needs to select the desired test as indicated by the dial, and the oscilloscope is then automatically configured to properly sense and display the anticipated electrical signal. To measure the electrical signal an active lead is attached to input port 16. A common lead provides a point of comparison for the active lead potential and is connected to common port 18. For most measurements the common lead is generally connected to ground. The off-on switch 20 permits the oscilloscope to be turned off and on. When pressed, the freeze button 22 stops the movement of waveforms on the display 12 and displays the waveform currently on the display as a still frame until the freeze button is pressed again. As is conventional, the freeze button allows time for the technician to examine the waveform.

Brief descriptions of the measurements typically associated with an automobile microchip, as indicated around the dial 14, are as follows.
- O2(15a): The measurement of oxygen in the exhaust stream. If the automobile is operating properly, the electrical signal should be a slow sine wave varying between 100 and 900 millivolts and centered at approximately 450 millivolts.
- TPS(15b): The throttle position sensor provides a measurement of the opening of the fuel throttle plate. As the accelerator pedal is depressed, a potentiometer is turned, resulting in a greater voltage across the potentiometer and thus a greater throttle aperture. When the potentiometer is worn, spikes or glitches may occur as the accelerator is depressed. When operating properly, the measured voltage should rise smoothly from 0 to 5 volts as the accelerator is depressed.
- DMAF(15c): The digitized measurement of the airflow into the engine. When operating properly the measured signal should be a 0 volt to 5 volt square wave with frequency proportional to the air flow measured.
- AMAF(15d): The analog measurement of the airflow into the engine. When operating properly the measured signal should be a sine wave which varies between 0 to 5 volts.
- AMAP(15e): The analog manifold absolute pressure of the air pressure at the manifold (it should be a consistent vacuum). The measured voltage level is an analog representation of the air pressure.
- DMAP(15f): The digital manifold absolute pressure of the air pressure at the manifold. The measured signal should be a square wave with a frequency that is proportional to the pressure.
- PFI(15g): The port fuel injector measures the voltage at fuel injector opening. The port fuel injector measurement may include spikes up to 100 volts.
- TBI(15h): The peak and hold fuel injector measures the voltage at the fuel injector opening for peak and hold variety injectors which peak twice.
- OPT Crank(15i): The optical crank takes an optical measurement of the crank shaft. A proper measured signal is a 0 volt to 5 volt square wave that has a frequency equal to that of the revolutions per minute of the crank shaft.
- OPT Cam(15j): The optical cam takes an optical measurement of the cam shaft (the cam shaft is the little shaft that operates the cylinder valves). A proper measured signal is a 0 volt to 5 volt square wave that has a frequency equal to that of the revolutions per minute of the cam shaft.
- MAG Crank(15k): The MAG Crank is a magnetic measurement of the crank shaft. A proper measured signal is a 0 volt to 5 volt sine wave with a frequency proportional to the revolutions per minute of the crank shaft.
- MAG Cam(15l): The MAG Cam is a magnetic measurement of the cam shaft. A proper measured signal is a 0 volt to 5 volt sine wave with a frequency proportional to the revolutions per minute of the cam shaft.
- LIVE Scope(15m): This position allows the user the full (i.e., wholly unconfigured) flexibility generally available with an oscilloscope.

The following controls are available when the dial 14 is in the LIVE Scope 15m position.
The volts per division button 24 sets the voltage (vertical) range of the oscilloscope 10 in terms of volts per horizontal division. In this instance a dual button 24 is provided, where pressing the top end of the button 24 increases the scale and pressing the bottom end of the button 24 decreases the scale. The preferred scaling uses a one-two-five sequence. Such a sequence may include 1 millivolt; 2 millivolts; 5 millivolts; 10 millivolts; 20 millivolts; 50 millivolts; 100 millivolts; 200 millivolts; 500 millivolts; 1 volt; 2 volts; 5 volts; 10 volts; 20 volts; 50 volts.
The position button 26 establishes the zero volt position on the vertical scale. For some measurements it would make sense for zero volt position to be at the very bottom of the scale (i.e. in the case where the voltage always exceeds zero), whereas for other measurements zero volt position should be in the middle of the vertical scale (i.e. for the cases where the voltage is centered at zero).
The Time/Div button 28 allows the user to set the time scale (horizontal) in terms of time per division. If the voltage varies over the course of microseconds, this should be set to approximately a microsecond per division. Where the voltage varies over the course of seconds, this should be set to approximately a second per division.
The trigger setting button 30 permits the triggering event that starts the scan to be fixed by the technician. In a typical implementation, the scan is always set to begin when the voltage increases above some predetermined amount. Alternatively, the trigger button could be configured to trigger on any other condition. The trigger feature allows a stable image to appear on the oscilloscope 10 and permits the capture of a rare event.
The live/stored button 32 allows the user to adjust the stored reference signal, described later, or the live image. When the button 32 is in "live" position, the other buttons act to adjust the live signal display. When the button 32 is in "stored" position, the other buttons 24, 26, 28, 30 act to adjust the display of the stored reference waveform.

The volts per division selected 33 is shown on the upper right of the display 12. The time per division selected 36 is displayed on the middle right and the trigger level voltage selected 37 is displayed at the lower right. The title of the test selected 40 is displayed at the upper left and the frequency of the signal acquired 42 is shown at the upper right of the display.

As previously mentioned, the sensing and displaying of electrical signals corresponding to each of the dial positions frees the user from configuring the oscilloscope. However, the user may still not be able to interpret the displayed waveform, or know how it should properly appear. To assist the user, a reference (i.e., exemplary) waveform corresponding to each test position on the dial is shown on the display when the dial is turned thereto. Each position on the dial corresponding to a particular test selects a set of waveform data from the internal memory of the oscilloscope which is representative of the reference waveform to be displayed. The oscilloscope then depicts this reference waveform on the display. The waveform data preferably includes more than merely the graphical image of the reference waveform. For example, the waveform data should also include the scaling data (voltage or current) and time duration data to properly configure the oscilloscope to display the reference waveform and to also properly display the sensed (live) waveform. Additionally, the waveform data should include the trigger level voltage and trigger slope so that all the proper settings are available for sensing and displaying the anticipated electrical waveform from the vehicle microchip or other test location. In other words, the reference waveform data selected by positioning the dial 14 will be displayed and the oscilloscope is properly configured to sense and also display the "live" electrical signal corresponding to the reference waveform. Preferably, the reference waveform and the live (actual) waveform are both displayed at the same time. However, if desired, a toggle switch may be used to select between the two waveforms. With both waveforms available, the user may compare the live waveform with the reference waveform to determine if the live waveform is proper.

An alternative to the dial 14 is to use one or more buttons to permit the user to scroll through test options that are preferably simultaneously displayed on the display and select the desired test. However, such a display system requires the pressing of several buttons to select the desired test and the user is more likely to inadvertently select the wrong test than if a rotary dial selector is used.

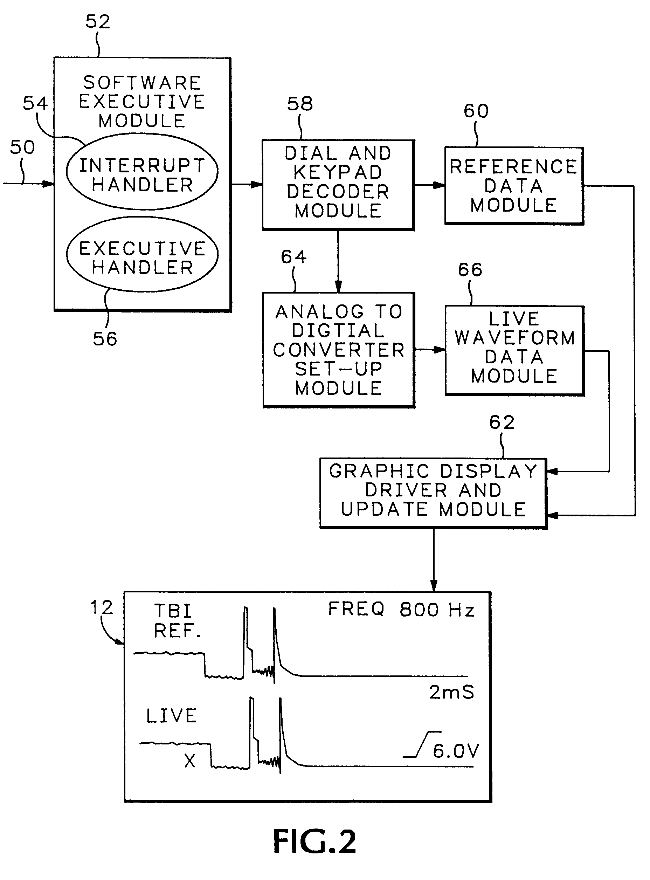

Referring to the operational flow diagram of FIG. 2, as the user turns the dial to the desired position a hardware interrupt 50 triggered by the dial is received by a Software Executive Module 52 which includes an Interrupt Handler 54 and an Executive Handler 56. The Dial and Keypad Decoder Module 58 receives the interrupt from the Software Executive Model 52 and then issues and passes to the Reference Data Module 60 an interrupt with a memory address corresponding to the graphical data for the reference waveform, as indicated by the dial 14. The Reference Data Module 60 uses the memory address to access a reference data library located in memory within the oscilloscope to retrieve the appropriate graphical data. The Reference Data Module 60 then passes the graphical data to the Graphic Display Driver and Update Module 62 which communicates with a graphical display microprocessor (not shown) by sending formatted data thereto, which in turn displays the reference waveform on the display 12. The graphical data also includes the name of the reference waveform which is shown in the upper left portion 40 of the display 12.

The Dial and Keypad Decoder Module 58 passes data to the Analog-to-Digital Converter Set Up Module 64 to set the analog-to-digital converters in the oscilloscope. These converters select the proper voltage scale, time duration, trigger level voltage, and trigger slope so that the input port 16 may properly sense the anticipated electrical signal and thereafter properly display it on the display 12. The digital data from Set Up Module 64 is passed to the Live Waveform Data Module 66, which in turn properly formats the data for the Graphic Display Driver and Update Module 62. The live data is then passed to the display through the Graphical Display Microprocessor. Both waveforms may be shown side-by-side, or up-and-down, or superimposed on-top-of-eachother on the display 12.

The terms and expressions which have been employed in the foregoing specification are used therein as terms of description and not of limitation, and there is no intention, in the use of such terms and expressions, of excluding equivalents of the features shown and described or portions thereof, it being recognized that the scope of the invention is defined and limited only by the claims which follow.

## Claims

1. A measuring device for displaying waveforms representative of electrical signals includes a selector, at least one input terminal, and a graphical display, said measuring device comprising:
(a) said graphical display suitable to display a waveform thereon;
(b) said measuring device receives an electrical signal from said input terminal and displays a first waveform on said graphical display representative of said electrical signal;
(c) said selector selectable to one of a plurality of positions;
(d) said measuring device selects waveform data in response to each of said positions; and
(e) said measuring device displays a second waveform on said graphical display representative of said waveform data.

2. The measuring device of claim 1 wherein said first waveform and said second waveform are displayed on different portions of said display.

3. The measuring device of claim 1 wherein said first waveform and said second waveform are displayed on the same portion of said display superimposed on each other.

4. The measuring device of claim 1 wherein said first waveform and said second waveform are displayed at the same time on said display.

5. The measuring device of claim 1 wherein said first waveform and said second waveform are displayed at different times on said display.

6. The measuring device of claim 1 wherein said waveform data includes scaling data.

7. The measuring device of claim 1 wherein said waveform data includes triggering data.

8. The measuring device of claim 1 wherein said waveform data includes graphical data representative of said second waveform displayed on said graphical display.

9. The measuring device of claim 1 wherein said second waveform is automatically displayed on said graphical display in response to said position of said selector.

10. The measuring device of claim 1 wherein said waveform data includes scaling data and time duration data.

11. The measuring device of claim 1 wherein said waveform data is retrieved from a memory within said measuring device.

12. The measuring device of claim 1 wherein said measuring device is an oscilloscope.

13. The measuring device of claim 1 wherein said measuring device samples said electrical signal at least with a rate of approximately 1,000,000 hertz.

14. The measuring device of claim 1 wherein said measuring device is handheld.

15. The measuring device of claim 1 wherein said first waveform is displayed on said display with the same scaling as said second waveform.

16. The measuring device of claim 1 wherein said selector is a dial.

17. The measuring device of claim 1 wherein said selector is a button that selects from a menu on said display.

18. A measuring device for displaying waveforms representative of electrical signals includes a selector, at least one input terminal, and a graphical display, said measuring device comprising:
(a) said graphical display suitable to display a waveform thereon;
(b) said selector selectable to one of a plurality of positions;
(c) said measuring device selects trigger data and scaling data in response to each of said positions; and
(d) said measuring device configured in accordance with said trigger data and scaling data receives an electrical signal from said input terminal and displays a received waveform representative of said electrical signal on said display.

19. The measuring device of claim 18 further comprising:
(a) said measuring device selects graphical data in response to each of said positions; and
(b) said measuring device displays a reference waveform on said display representative of said graphical data.

20. The measuring device of claim 18 wherein said received waveform and said reference waveform are displayed on different portions of said display.

21. The measuring device of claim 18 wherein said received waveform and said reference waveform are displayed on the same portion of said display superimposed on each other.

22. The measuring device of claim 18 wherein said received waveform and said reference waveform are displayed at the same time on said display.

23. The measuring device of claim 18 wherein said received waveform and said reference waveform are displayed at different times on said display.

24. The measuring device of claim 18 wherein said scaling data includes time scaling.

25. The measuring device of claim 18 wherein said scaling data includes voltage scaling.

26. The measuring device of claim 18 wherein a trigger level voltage is selected in response to each of said positions.

27. The measuring device of claim 19 wherein said graphical data is retrieved from a memory.

28. The measuring device of claim 18 wherein a trigger slope is selected in response to each of said positions.

29. The measuring device of claim 18 wherein said measuring device is an oscilloscope.

30. The measuring device of claim 18 wherein said measuring device samples said electrical signal at least with a rate of approximately 1,000,000 hertz.

31. The measuring device of claim 18 wherein said measuring device is handheld.

32. The measuring device of claim 19 wherein said reference waveform and said received waveform are displayed on said display with the same scaling.

33. The measuring device of claim 18 wherein said selector is a dial.

34. The measuring device of claim 18 wherein said selector is at least one button that selects an item from a menu on said display.
